# EUROPEAN PATENT APPLICATION

(11) **EP 4 632 116 A1**
(43) Date of publication of application: **15.10.2025**
(21) Application number: 24169106.2
(22) Date of filing: 09.04.2024
(51) Int. Cl.: C30B 23/02, C30B 29/36, C30B 29/40

(54) **LAYERED SEED, METHOD OF FABRICATION OF A LAYERED SEED AND METHOD FOR GROWING A VOLUME MONO CRYSTAL WITH THE LAYERED SEED**

(71) Applicant: SiCrystal GmbH, 90411 Nürnberg (DE)
(72) Inventor: Ecker, Bernhard, 90411 Nürnberg (DE); Klietz, Wenzel, 90411 Nürnberg (DE); Müller, Ralf, 90411 Nürnberg (DE); Schuh, Philipp, 90411 Nürnberg (DE); Stockmeier, Matthias, 90411 Nürnberg (DE); Vogel, Michael, 90411 Nürnberg (DE)
(74) Representative: Grünecker Patent- und Rechtsanwälte PartG mbB

(57) **Abstract**

The present disclosure relates to a layered seed for growing a volume mono crystal by gas phase growth in a direction of growth (Y) in a crucible (1200). The layered seed comprises a monocrystalline growing layer (110) with a growing surface (112) for growing the volume mono crystal and an opposing heat spreader facing surface (114) for coupling the growing layer (110) to a heat spreader layer (140). The layered seed further comprises the heat spreader layer (140) with a growing layer facing surface (144) for coupling to the heat spreader facing surface (114) and an opposing mounting surface (142) for mounting the heat spreader layer (140) to the crucible (1200), wherein the heat spreader layer (140) comprises a polycrystalline material having thermally coupled grains (146) that are piled in the direction of growth (Y), the piled grains (146) for equalizing hot spots of the crucible thermally coupled to the mounting surface (142).

## Description

### TECHNICAL FIELD OF THE INVENTION

The present invention relates to a layered seed, method of fabrication of a layered seed and method for growing a volume mono crystal with the layered seed.

### BACKGROUND OF THE INVENTION

Semiconductor materials such as silicon carbide (SiC) are commonly used in the manufacture of electronic components. SiC is a compound semiconductor that forms the basis for power electronic components, e.g. in the automotive and green energy sectors.

Using a suitable source material, the volume mono crystals are typically grown by gas phase growth as a physical vapor deposition (PVT) process. Substrates are then fabricated from the grown volume mono-crystals using e.g. multi-wire saws and the surface is then refined using multi-stage polishing steps. In a subsequent epitaxial process, thin single crystal layers (e.g. SiC, GaN) are deposited on the substrates. The properties of these layers and the devices fabricated from them depend crucially on the quality of the SiC substrate.

The basic principle of mono crystal growth is based on the sublimation of a starting material and the subsequent transport of the species in the gas phase (SiC, Si2C, SiC2) to a seed on which the material is deposited and the volume mono crystal grows. The quality of the seed is extremely important to ensure low defect density in the growing crystal. Substrates are then fabricated from the bulk mono crystals. Due to the increasing demand for high quality substrates for the production of electrical components, the use of high quality seeds for the growth process is essential to grow crystals of the highest possible quality.

Several factors influence the growth of mono crystals using a sublimation process such as the PVT process. The factors discussed below are those that are particularly critical with respect to the PVT process. However, those skilled in the art will know that other sublimation processes, such as the gradient freeze method, the horizontal Bridgman technique, the vapor-liquid-solid (VLS) method, the chemical vapor transport (CVT) method, the zone melting method, and the laser-heated floating zone (LHFZ) method, may have the same or similar limitations.

Particularly in the present application, the temperature distribution within the PVT system is critical for controlling crystal growth. The temperature gradient between the source material and the seed crystal determines the rate of vapor transport and deposition. Optimizing the temperature profile helps to achieve uniform crystal growth and minimize defects.

Another factor is the quality and orientation of the seed crystal, which plays a critical role in determining the quality and orientation of the grown volume monocrystal. The seed crystal provides a template for crystal growth, and defects, stresses, or misorientations in the seed crystal can propagate into the grown crystal. Therefore, selecting high quality seed crystals with the desired crystallographic orientation is critical.

Other effects that have a major impact on the PVT process include
- the pressure within the PVT system, which affects vapor transport and deposition kinetics;
- the purity of the starting material, which directly affects the quality of the resulting monocrystal;
- the composition of the gas atmosphere in the PVT system, which affects crystal growth kinetics and defect formation,
- the control of various process parameters such as heating rate, cooling rate, growth time, and seed crystal rotation speed, which can affect crystal growth kinetics and morphology; and
- the design and material of the crucible used to contain the seed material also influence crystal growth.

In view of the above considerations, EP 1 200 651 proposes a lateral support of the seed to allow the growth of high quality crystals. However, this solution has some drawbacks. For example, the lateral support places stress on the seed, which reduces the quality of the seed. In addition, the support material, which comprises a metal, is different from the seed material and therefore has different thermal properties that affect the temperature gradient in the crucible. In addition, the support material can contaminate the gas atmosphere in the PVT system and change the pressure in the PVT system.

### SUMMARY OF THE INVENTION

The present invention has been made in view of the shortcomings and disadvantages of the prior art, and an object thereof is to provide an improved seed coupling to the crucible which eliminates or at least mitigates the above disadvantages and shortcomings of the related prior art.

This object is solved by the subject matter of the independent claims. Advantageous embodiments of the present invention are the subject matter of the dependent claims.

In particular, the subject is solved by a layered seed. The layered seed comprises, in addition to the monocrystal growing layer, a heat spreading layer comprising a polycrystalline material. This enables the growth of high quality SiC single crystals from which high quality SiC substrates can be produced. Due to the temperature levelling effect of the multilayer seed, growth inhomogeneities can be reduced. This increases the quality of the crystals and the wafers produced from them. These wafers have reduced thermal stress and therefore improved geometry. These wafers also contain fewer impurities, dislocations, local polytype changes, and stacking defects.

A first aspect relates to a layered seed for growing a volume mono crystal by gas phase growth, e.g. sublimation growth or High Temperature Chemical Vapor Deposition (HTCVD) in a direction of growth in a crucible. The layered seed comprises a monocrystalline growing layer with a growing surface for growing the volume mono crystal and an opposing heat spreader facing surface for coupling the growing layer to a heat spreader layer. Further, the layered seed comprises the heat spreader layer with a growing layer facing surface for coupling to the heat spreader facing surface and an opposing mounting surface for mounting the heat spreader to the crucible, wherein the heat spreader layer comprises a polycrystalline material having thermally coupled grains that are piled in the direction of growth, the piled grains for equalizing hot spots of the crucible thermally coupled to the mounting surface.

The first aspect facilitates to level a temperature profile with hot spots coupled in the layered seed at the mounting surface so that that temperature profile at the growing surface is smoother thereby improving the quality of the volume mono crystal.

A second aspect relates to a seed according to aspect 1, wherein the monocrystalline growing layer has a thickness in the direction of growth of equal to or greater than 0.5 mm and/or less than or equal to 1.0 mm, and/or wherein the heat spreader layer has a thickness in the direction of growth of equal to or greater than 0.5 mm and/or less than or equal to 3.0 mm. Optionally the layered seed has a diameter in a radial dimension of equal to or greater than 155 mm, preferably equal to or greater than 210 mm and/or less than or equal to 360 mm, the radial dimension is perpendicular to the direction of growth.

The second aspect facilitates to level a temperature profile by selecting appropriate parameter for thickness and diameter thereby improving the quality of the volume mono crystal.

A third aspect relates to a seed according to any of the proceeding aspects, wherein a median grain diameter, D50, is equal to or greater than 3 µm and/or less than or equal to 80 µm, preferably wherein D50 is equal to or greater than 3 µm and/or less than or equal to 50 µm. Optionally wherein a number of grains piled in the heat spreader layer in the direction of growth is equal to or greater than 167 and/or less than or equal to 1000.

The third aspect facilitates to level a temperature profile by selecting a grain parameters thereby improving the quality of the volume mono crystal.

A fourth aspect relates to a seed according to any of the proceeding claims, wherein the monocrystalline growing layer comprises a first material, the first material being at least one of Si, SiC, AIN, GaN, AlGaN, AllnN, and InN, and/or the grains of the heat spreader layer comprise a second material, the second material being at least one Si, SiC, AIN, GaN, Al2O3 , GaAs and oxide substrate. Optionally the second material is identical to the first material and the first material being at least one of Si, SiC, AIN, and GaN, or wherein the first material is different from the second material. Optionally the monocrystalline growing layer consists of the first material.

The fourth aspect facilitates to level a temperature profile by selecting a seed layer materials thereby improving the quality of the volume mono crystal.

A fifth aspect relates to a seed according to any of the proceeding aspects, wherein the heat spreader layer comprises a third material, the third material being a metal, preferably, wherein the third material being at least one of Ti, Fe, W, Mo, and V.

The fifth aspect facilitates to level a temperature profile by adding impurities to the heat spreader layer thereby improving the quality of the volume mono crystal.

A sixth aspect relates to a seed according to any of the proceeding aspects, wherein the grains of the heat spreader layer comprise a second material and the heat spreader layer comprises a third material, the third material having a higher mass than the second material. Optionally the heat spreader layer comprises the third material at a grain boundary between abutting grains.

The sixth aspect facilitates to level a temperature profile for the same reasons as the fifth aspect, in particular by adding high mass impurities to the grain boundaries thereby improving the quality of the volume mono crystal.

A seventh aspect relates to a seed according to any of the proceeding aspects, wherein the heat spreader layer comprises a concentration of impurities, wherein the concentration is equal to or greater than 5 ppm, even more preferably 10 ppm and/or less than or equal to 1000 ppm.

The seventh aspect facilitates to level a temperature profile for the same reasons as the fifth and sixth aspect, in particular by adding certain amount of impurities to the heat spreader layer thereby improving the quality of the volume mono crystal.

An eighth aspect relates to a seed according to any of the proceeding aspects, wherein an angle between a crystallographic axis of the monocrystalline growing layer and a surface normal of the growing surface is equal to or greater than 0° and/or less than or equal to 8°, preferably the angle is equal to or greater than 2° and/or less than or equal to 6°.

The eighth aspect facilitates mitigate effects of a temperature profile by enabling step growth thereby improving the quality of the volume mono crystal.

A ninth aspect relates to a seed according to any of the proceeding aspects, wherein the growing surface (112) comprises a carbon face, C-face, preferably the growing surface is a C-face.

The ninth aspect facilitates mitigate effects of a temperature profile by improving the growing using a C-face thereby improving the quality of the volume mono crystal.

A tenth aspect relates to a seed according to any of the proceeding aspects, further comprising a connecting layer between the monocrystalline growing layer and the heat spreader layer, wherein the connecting layer preferably comprises at least one of a phenolic resin, novolac resin, and sintered powder, preferably sintered silicon powder.

The tenth aspect facilitates to level the temperature profile by combining the multiple layer thereby improving the quality of the volume mono crystal.

An eleventh aspect relates to a method for fabricating a layered seed for growing a volume mono crystal by gas phase growth in a direction of growth in a crucible, the method comprises the steps of:
providing a monocrystalline growing layer with a growing surface for growing the volume mono crystal and an opposing heat spreader facing surface for coupling the growing layer to a heat spreader layer; and
providing the heat spreader layer with an growing layer facing surface for coupling to the heat spreader facing surface and an opposing mounting surface for mounting the heat spreader to the crucible,
wherein the heat spreader layer comprises a polycrystalline material having thermally coupled grains that are piled in the direction of growth, the piled grains for equalizing hot spots of the crucible thermally coupled to the mounting surface, and
connecting the growing layer facing surface to the heat spreader facing surface.

The eleventh aspect facilitates to level a temperature profile for the same reasons as the first to tenth aspect.

A twelfth aspect relates to a method according to aspect eleven, wherein the growing layer facing surface is connected to the heat spreader facing surface by a at least one of a gluing step and a sintering step for forming a connecting layer between the monocrystalline growing layer and the heat spreader layer.

The twelfth aspect facilitates to level a temperature profile by a uniform thermal coupling between the multiple layers thereby improving the quality of the volume mono crystal.

A thirteenth aspect relates to a method for growing a volume mono crystal in a direction of growth, the method comprising the steps of:
Mounting a layered seed according to any of aspects 1 to 10 or a layered seed fabricated according to the method of aspects 11 to 12 in a crucible,
Growing, by a gas phase growth process, the volume mono crystal on the monocrystalline growing layer.

The thirteenth aspect facilitates improving the quality of the volume mono crystal by levelling a temperature profile for the same reasons as the first to twelfth aspect.

A fourteens aspect relates to a method according to aspect 13 wherein the heat spreader layer is mounted to a seed holder in the crucible. Optionally the mounting layer is glued or sintered to the seed holder. Optionally the heat spreader layer is clamped by the seed holder.

The fourteens aspect facilitates improving the quality of the volume mono crystal by levelling a temperature profile for the same reasons as the first to twelfth aspect.

A fifteens aspect relates to a method according to any of aspects 13 to 14, wherein the volume mono crystal is grown by physical vapor transport (PVT). Optionally wherein growing comprises heating the layered seed to a temperature of equal to or greater than 2000°C and/or less than or equal to 2400°C.

The fifteens aspect facilitates improving the quality of the volume mono crystal by levelling a temperature profile for the same reasons as the first to twelfth aspect.

### BRIEF DESCRIPTION OF THE FIGURES

The accompanying drawings are incorporated into the specification and form a part of the specification to illustrate several embodiments of the present invention. These drawings, together with the description serve to explain the principles of the invention. The drawings are merely for the purpose of illustrating the preferred and alternative examples of how the invention can be made and used, and are not to be construed as limiting the invention to only the illustrated and described embodiments. Furthermore, several aspects of the embodiments may form-individually or in different combinations-solutions according to the present invention. The following described embodiments thus can be considered either alone or in an arbitrary combination thereof. Further features and advantages will become apparent from the following more particular description of the various embodiments of the invention, as illustrated in the accompanying drawings, in which like references refer to like elements, and wherein:
- FIG. 1: is a schematic view of a layered seed according to an example;
- FIG. 2: is a further schematic side view of the layered seed according to an example;
- FIG. 3: a further schematic side view of the layered seed according to an example;
- FIG. 4: is a schematic view of a growing arrangement; and
- FIG. 5: schematic view of a layered seed.

### DETAILED DESCRIPTION

### Gas phase growth

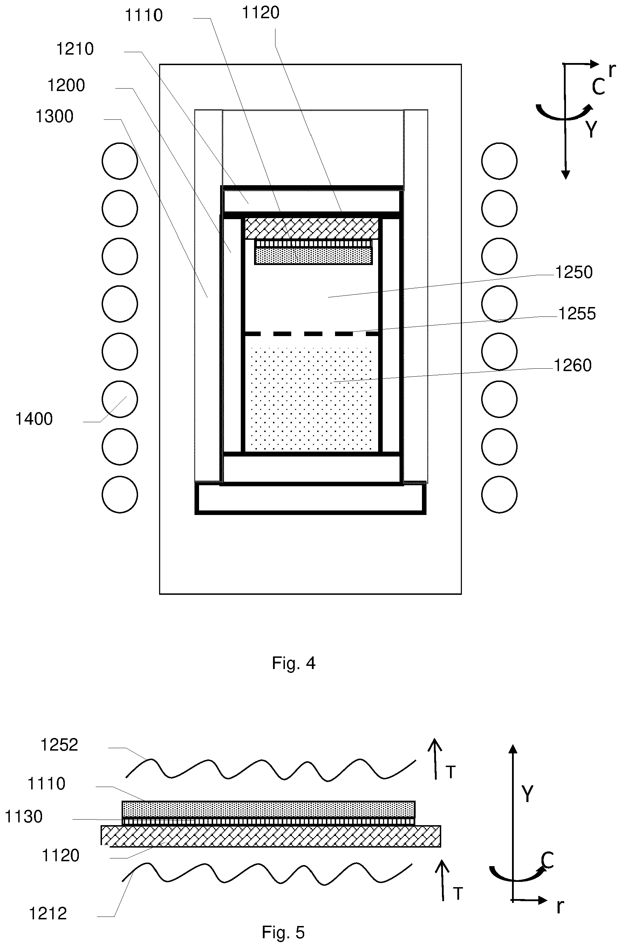

Volume mono crystals are grown by gas phase growth, e.g. sublimation growth. FIG. 4 shows an exemplary sublimation growth system 1000, in particular a PVT crystal growth system, carried out in a crucible 1200. A crucible is a container in which materials, e.g. SiC, can be exposed to very high temperatures (above 2000°C), e.g. a temperature that allows sublimation of SiC. In particular, the crucible is made of a material that can withstand temperatures high enough to melt and/or sublime its contents.

As shown in FIG. 4, the crucible 1200 is placed in a tubular container 1300, which may be made of quartz glass, and is surrounded by an induction heater 1400. Alternatively, the tubular container could be made of stainless steel and the heater could be a resistance heater. The parts together form a reactor, which is the core of the system 1000. The tubular container 1300 is a machine used to perform processes that require elevated temperature and pressure relative to ambient pressure and/or temperature.

The actual crystal growth takes place inside the crucible 1200. The walls of the crucible 1200 can be made of materials such as graphite and carbon. These materials allow the crucible 1200 to heat the growth material, e.g. SiC, to growth temperatures in excess of 2000°C.

In particular, for growing the SiC volume monocrystal, a SiC seed crystal 1110 is disposed on a seed holder 1120 which is disposed on an end wall 1210 of the crucible 1200 prior to the start of growth. More specifically, the SiC seed crystal 1110 is disposed in a crystal growth region 1250 of the growth crucible, which is preferably completely closed, in particular at least during growth.

Powdered SiC source material is introduced into a storage region 1260 of the growth crucible. A thick dashed line 1255 indicates a boundary of the storage region 1260 at the start of the growth process. The boundary is, for example, a wall of porous graphite. During the growth, a SiC growth gas phase is produced there by sublimation of the powdered SiC source material and by transport of the sublimated gaseous components into the crystal growth region 1250, and the SiC volume monocrystal with a central longitudinal axis along the Y-axis grows, in particular by deposition from the SiC onto the SiC seed crystal 1110.

To grow the SiC volume monocrystal, a temperature distribution along the Y-axis is realized in the crucible. In general, the highest temperature is usually in the storage region 1260 and the seed 1110 is at a lower temperature so that the gaseous material condenses.

As shown in FIG. 4, heating can be provided either by induction coils 1400 located outside the tubular container 1200. In particular, the induction coils 1400 are arranged along a circumferential direction C. Alternatively, according to a solution not shown, resistance heaters can be placed inside the reactor 1300.

Induction heating is the process of heating electrically conductive materials by electromagnetic induction, by current passing through the inductor 1400, which creates an electromagnetic field within the coil to directly heat the material in the SiC storage region 1160 and/or to heat a side wall of the crucible to indirectly heat the SiC in the storage region. The side wall of the crucible extends along the circumferential direction along the growth direction, i.e., the Y axis. The insulation thermally insulates the crucible and a cavity formed inside the crucible. Notably, the above discussed metal seed holder may be heated by the induction coil, and thus, influence the temperature distribution.

### Temperature distribution

As discussed above, thermal gradients are critical to crystal quality. In particular, when growing SiC mono crystals using the PVT process, temperature gradients in the axial Y and radial r directions must be precisely controlled to produce high-quality mono crystals.

For example, the axial Y temperature gradient from the SiC source material in the source region 1260 to the seed 1210 determines the growth rate. Further, as discussed for example in US 8,865,324 B2, a radial temperature gradient in the radial direction r can be set so that a convex crystal is formed. This prevents the ingrowth of edge defects that can occur when the growing crystal comes into unavoidable contact with the wall of the growth crucible.

In particular, excessive convexity is detrimental to the quality of the SiC substrates produced from it, e.g. increased dislocation densities and increased bow and warp geometry values due to the thermal stress introduced into the crystal.

For this purpose, the components of the growth crucible, in particular a crystal channel and an end wall 1210, are manufactured in defined geometries and made of materials, in particular graphite, with defined thermal properties, in particular with regard to heat conduction. The crystal channel is a cylindrical arrangement mounted inside the cylinder at its end. The seed holder 1120 closes the crystal channel on the end of crucible where the end wall 1210, also referred as lid, is placed to close the crucible. The crystal channel defines the maximum diameter the crystal can achieve. The porous membrane has pores, where the gas species can enter the crystal channel, coming from a source compartment.

### Further improvements

In addition to the temperature distribution along the growth axis Y and r discussed above, investigations have shown that thermal coupling of the seed to the crucible 1200 can result in local deviations from the desired temperature field at a mounting surface that are conducted to a growing surface.

It has been found that even with the most favorable thermal gradients along the radial axis r and the growth axis Y, the resulting crystals do not exhibit the expected quality. In particular, it has been found that this is due to the non-optimal thermal coupling of the seed 1110 to the growing structure, in particular to the end wall 1210.

More particularly, FIG. 5 shows the seed holder 1120, the seed crystal 1110, and a connecting layer 1130 between the seed holder 1120 and the seed crystal 1110 of FIG. 4. In addition, FIG. 5 shows the temperature distribution 1212 in the end wall 1210 of FIG. 4 relative to a desired temperature distribution, which is not shown. As shown in FIG. 5, this temperature distribution 1212 may have a non-uniform distribution in the radial direction r. This temperature distribution 1212 is coupled to the seed holder 1120.

It has also been found that the temperature distribution 1212 results in local deviations from the desired temperature field at the growing surface, i.e. the phase boundary of the growing seed, as indicated by the temperature profile 1252.

This can lead to localized island growth, which can have a negative impact on the quality of the growing crystal. The coincidence of growth fronts due to island growth can result in a variety of defects ranging from macroscopic features, such as polytype changes and foreign grains, to microscopic defects, such as dislocations and stacking faults, which reduce the quality of the resulting crystal.

In other words, the temperature distribution 1252 affects the quality of the volume mono crystal. The technical problem to be solved is to optimize the temperature distribution 1252 at the growing surface of the seed.

The inventors have therefore identified the possibility of providing an improved seed, an improved fabrication method and an improved growing method to avoid one or more of the disadvantages described above. The present invention relates to various solutions and variants for such an improved seed.

### Solutions

In the following, different implementations and variants will be explained. The following disclosure was facilitated by the discussions and findings as described above and may for example be based at least on part thereof.

In general, it should be noted that many assumptions have been and are made herein so as to be able to explain the principles underlying the present disclosure in a clear, concise and understandable manner. These assumptions are however to be understood merely as examples made herein for illustration purposes, which are not necessarily essential for the invention and should thus not limit the scope of the disclosure. A skilled person will be aware that the principles of the following disclosure and as laid out in the claims can be applied to different scenarios and in ways that are not explicitly described herein.

For example, a **seed** is a small, specially prepared crystal that is used as a starting point in the process of growing larger crystals with desired properties. It serves as a template upon which the new crystal can grow, aligning its lattice structure with that of the seed crystal. Typically in SiC PVT growth the diameter of the seed is in the same range as the resulting crystal grown on it. In terms of length, it is a small/short disc.

Furthermore, a **volume mono crystal** refers to a single crystal structure that extends through the entire volume of the material, ideally without grain boundaries or defects that would disrupt the crystal lattice. In other words, it's a solid material that consists of a single continuous crystal, rather than many smaller crystals (polycrystalline) or an amorphous structure. In a bulk mono crystal, the atoms or molecules are arranged in a highly ordered, repeating pattern throughout the material. This results in properties such as uniformity of mechanical, electrical, and optical properties in all directions, making mono crystals highly desirable for various applications in electronics, optics, and materials science.

In addition, a **heat spreader** is a component used to more effectively and uniformly dissipate heat across a surface. It's designed to transfer heat away from heat-generating components, such as the end wall 1210, coupled to a mounting surface and distribute it over a growing layer facing surface, thereby reducing localized hot spots on the end wall 1210.

A **polycrystalline material** is a type of solid material composed of multiple crystalline grains. Each grain within the material has its own crystal structure, orientation, and lattice arrangement. These grains are typically randomly oriented with respect to each other, forming boundaries known as grain boundaries.

Unlike single crystal materials, where the entire structure consists of a continuous lattice with no grain boundaries, polycrystalline materials have distinct grains separated by these grain boundaries. Each grain may have slightly different physical and chemical properties due to variations in crystal orientation, defects, impurities, or processing conditions.

Further, **piled grains** is used herein to describe a plurality of grains placed on top of each other in a disorderly or haphazard manner to form a layer. The arrangement may be irregular and the objects may not be neatly aligned.

A **layer** is a specific thin structure that can be deposited on another structure or layer. A layer can be made up of different materials and have specific functions, such as growing structures, connecting other layers, or dissipating heat.

### First solution - layered seed

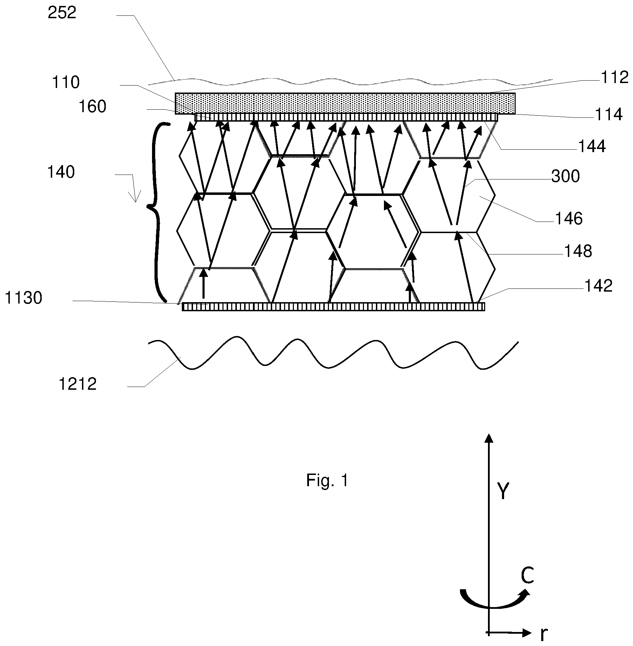

FIG. 1 shows a layered seed for growing a volume mono crystal by gas phase growth in a direction of growth Y in a crucible according to an example according to a general solution. In particular, the layered seed comprises a monocrystalline growing layer 110 and a heat spreader layer 140.

The monocrystalline growing layer 110 has a growing surface 112 for growing the volume mono crystal and an opposite heat spreader facing surface 114 for coupling the growing layer 110 to the heat spreader layer 140.

The heat spreader layer 140 has a growing layer facing surface 144 for coupling to the heat spreader facing surface 114 and an opposing mounting surface 142 for mounting the heat spreader to the crucible. Thermal coupling refers to the process by which two or more objects or systems come into contact with each other and exchange thermal energy. When objects are thermally coupled, heat can flow between them due to a temperature difference, leading to a change in temperature in one or both of the objects until they reach thermal equilibrium, where their temperatures are equal.

The heat spreader layer 140 comprises a polycrystalline material having a plurality of thermally coupled grains 146 that are piled in the direction of growth Y. As shown in FIG. 1, abutting piled grains 146 are separated by grain boundaries 148.

Also shown in Figure 1 are phonons 300. A phonon is a quasiparticle in a crystalline lattice of atoms or molecules that represents the vibrational energy of the lattice. In simpler terms, a phonon is a unit of vibrational energy that propagates through a solid material in much the same way that a photon carries energy in a wave. Phonons carry thermal energy through a material by transferring vibrational energy from one atom to another.

At a grain boundary 148, which, as described above, is the interface between two adjacent crystalline grains 146 in the polycrystalline heat spreader layer 140, the behavior of phonons 300 differs from their behavior within the grain 146. In particular, phonons 300 may be scattered at grain boundaries 148, resulting in phonon reflection, transmission, or conversion to other types of vibrational modes.

Given the plurality of piled grains 146, the piled grains 146 equalize hot spots in the temperature profile 1212 of the crucible 1200 thermally coupled to the mounting surface 142 into a balanced temperature profile 252. Notably, FIG. 1 shows the temperature profile without the global radial temperature profile.

In other words, the use of a polycrystalline layer, e.g. a polycrystalline SiC layer, in combination with a monocrystalline layer, e.g. a monocrystalline SiC layer, as a layered seed, i.e. a multilayer seed system, has the advantage that thermal inhomogeneities 1212 are compensated by the grain boundaries 148 in the polycrystalline layer 140.

These inhomogeneities 1212, which may originate from inhomogeneities of the materials used for the growth structure, e.g. graphite, as a result of which the heat does not reach the seed 110 uniformly. The thermal coupling to the seed holder 1120 may also be negatively affected by unwanted thermal contacts or contact losses, e.g. due to the different thermal expansion of the materials used in the crucible.

The mechanism for thermal levelling takes place via heat dissipation at the internal grain boundaries 148 of the polycrystalline layer, e.g. a SiC wafer. The number of grains 146 and the resulting grain boundaries 148 to be crossed in the polycrystalline layer 140 result in a homogeneous temperature field for the subsequent monocrystalline layer 110, e.g., a monocrystalline SiC layer.

### First implementation - dimensions of the layers

According to an implementation of the first solution, various dimensions of the layers can be considered. In more detail, as discussed above, the layered seed comprises layers where the thickness is small compared to the diameter. The thickness of the layers is measured here in the direction of growth Y. The diameter of the layers is measured in the radial direction r. The radial dimension is perpendicular to the direction of growth Y.

For example, the thickness of the monocrystalline growing layer 110 can range from a few hundred micrometers to several millimeters, depending on the application. Thinner seed crystals may be used for certain applications where precise control over crystal orientation or morphology is required, while thicker seed crystals may be preferred for larger-scale production or to accommodate specific growth conditions. Preferably, the thickness of the seed layer 110 is equal to or greater than 0.5 mm. Additionally or alternatively, the thickness of the seed layer 110 is less than or equal to 1.0 mm.

Furthermore, the thickness of the layered seed can have a constraint for the total thickness, which can be between a minimum of 1.5 mm to a maximum of 3.5 mm. Thus, the optimum thickness of the heat spreader layer in the growth direction Y of the same can be greater than 0.5 mm. Additionally or alternatively, the thickness of the heat spreader layer can be less than or equal to 3.0 mm.

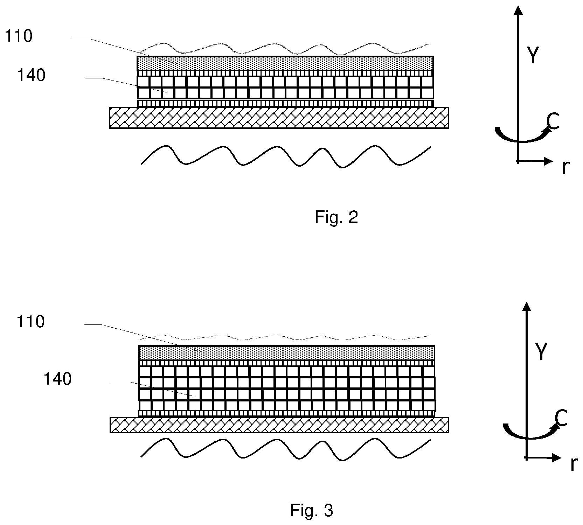

FIG. 2 shows a layered seed with a heat spreader layer 140 that is thin compared to the heat spreader layer 140 in the layered seed shown in FIG. 3. Notably, FIGS. 2 and 3 show the temperature profile without a global radial temperature profile. In other words, the leveling effect of the heat spreader layer is proportional to the thickness of the heat spreader layer. Consequently, a thicker layer will increase the leveling effect. However, as discussed above, a radial temperature profile can couple to the layered seed to allow for convex growth. Therefore, the thickness can be limited to allow for convex growth.

Further, the layered seed can have a diameter in a radial dimension r, which influences the diameter of the resulting volume mono crystal. The volume mono crystal may have a diameter of equal to or greater than 150 mm, preferably equal to or greater than 200 mm and/or less than or equal to 300 mm. The layered seed than has a diameter that is 5 to 20 % larger. In particular, the layered seed can have a diameter of equal to or greater than 155 mm. Preferably the layered seed has a diameter of equal to or greater than 210 mm. Additionally or alternatively, the layered seed has a diameter of less than or equal to 360 mm.

Thus, the layered seed can be used to grow crystals from which substrates with diameters of approximately 150 mm, 200 mm and 300 mm can be produced. The heat spreader layer can also have a larger diameter than the monocrystalline growing layer.

The thickness and/or diameter values are particularly applicable to a heat spreader layer containing or consisting of SiC.

### Second implementation - dimensions of the grains

According to a second implementation of the first solution, in addition or alternatively to the thicknesses of the heat spreader layer 140 described in the first implementation, parameters relating to the grains 146 in the polycrystalline layer can be used as another control variable. The median grain size (D50) in polycrystalline materials refers to the size of the grains in the microstructure of the material, where half of the grains are smaller and half are larger than the median grain size. The influence of median grain size on polycrystalline materials is significant and affects various mechanical, thermal, electrical and optical properties.

For example, as discussed above, the presence of grain boundaries 148 can impede the propagation of phonons, thereby reducing the thermal conductivity of the material. A smaller D50 will typically result in more grain boundaries, leading to a higher leveling effect.

In addition, a smaller D50 tends to improve the mechanical properties of polycrystalline materials. This is because smaller grains create more grain boundaries, which act as barriers to dislocation motion and increase the strength and hardness of the material. However, excessively small grains can also result in reduced ductility and toughness.

In particular, D50 can be equal to or greater than 3 µm. Additionally or alternatively, D50 may be less than or equal to 80 µm. Preferably, D50 is less than or equal to 50 µm. The D50 values are particularly applicable to a heat spreader layer comprising or consisting of SiC.

For example, given the above parameters for thickness and a D50 of 3 µm , the number of grains piled in the growth direction Y in the heat spreader layer is equal to or greater than 167 and/or less than or equal to 1000.

### Third implementation - dimensions of the grains

The above description is mainly based on the assumption that the monocrystalline growth layer and the heat spreader layer are made of SiC. According to a third implementation, alternative materials can be used to produce high quality crystals. The heat spreader layer and the monocrystalline growing layer of the layered seed can form a homostructure or a heterostructure. The main difference between a homostructure and a heterostructure is the composition of the semiconductor materials within the layered seed. Homostructures consist of layers of the same semiconductor material, while heterostructures consist of layers of different semiconductor materials. Each type of structure offers distinct advantages and is used in different semiconductor devices depending on the desired properties and functionality.

For example, homostructures are commonly used in devices such as bipolar junction transistors (BJTs) or metal-oxide-semiconductor field-effect transistors (MOSFETs), where device characteristics are optimized by adjusting the doping concentration or thickness of the same semiconductor material. Heterostructures enable the creation of novel electronic and optoelectronic devices with enhanced functionality, such as improved carrier confinement, bandgap engineering, and increased electron mobility.

The above description is mainly based on the assumption that the monocrystalline growing layer and the heat spreader layer comprise SiC. Alternative materials can be used for the production of high-quality crystals. The heat spreader layer and the monocrystalline growing layer of the layered seed can in form a homo- or a heterostructure.

For example, the monocrystalline growing layer may comprise or consist of a first material, wherein the first material is at least one of Si, SiC, AIN, GaN, AlGaN, AllnN, and InN.

Additionally or alternatively, the grains of the heat spreader layer comprise or consist of a second material, wherein the second material is at least one of Si, SiC, AIN, GaN, Al2O3, GaAs, and oxide substrate. An oxide substrate refers to a material, typically a crystalline structure, composed primarily of oxides. Oxides are chemical compounds containing at least one oxygen atom and one other element.

As discussed above, for a homostructure, the second material is identical to the first material. For example, the homostructure material can be at least one of Si, SiC, AIN, and GaN.

As discussed above, for a heterostructure, the first material is different from the second material. For example, the heat spreader layer can comprise SiC and the monocrystalline growing layer can comprise any of Si, AIN, GaN, AlGaN, AllnN, and InN.

Polycrystalline SiC can be used as heat spreader forming a heterostructure with monocrystalline AIN for improved growth of AIN monocrystals, having a low lattice constant mismatch. Advantageously, polycrystalline Si can be used as cheap and easily accessible heat spreader in conjunction with a SiC monocrystalline layer to improve SiC monocrystal growth.

Notably, the monocrystalline growing layer can consist of the first material or may comprise the first material and some dopant atoms. Similarly, the heat spreader layer growing layer can consists of the second material or may comprise the second material and some impurities. These dopant atoms and impurities may not be considered in defining that the seed layer is a homostructure.

### Fourth implementation - Impurities

According to a fourth implementation of the first solution, additional elemental impurities may be introduced in the polycrystalline layer. This may happen during the formation of the polycrystalline heat spreader layer. For example, the impurities accumulate at the grain boundaries due to grain boundary segregation. Grain boundary segregation refers to the phenomenon in which certain atoms or molecules preferentially accumulate or segregate at the boundaries between grains in a polycrystalline material. These impurities, also referred to as foreign atoms, that accumulate at the grain boundaries can act as more effective scattering centers for the phonons than the grain boundaries themselves due to their comparatively higher mass.

The heat spreader layer comprises for example a concentration of impurities, wherein the concentrations are equal to or greater than 5 ppm, preferably 10 ppm and/or less than or equal to 1000 ppm.

For example, the grains of the heat spreader layer can comprise a second material, for example the materials described above, e.g. Si, SiC, AIN, GaN, Al2O3, GaAs and oxide substrate. In addition, the heat spreader layer can comprise the impurities of a third material, for example, the third material can be a metal such as Ti, Fe, W, Mo, and V. The third material has a higher mass than the second material so that phonons are scattered more efficiently.

The mass of an atom or molecule is typically measured in units of atomic mass (u). The atomic mass of an element, such as W=183.84 u, is usually listed in the periodic table. The mass of molecules, such as SiC= 40.1 u, is determined by summing the atomic masses of all the atoms that make up the molecule.

As discussed above, the heat spreader layer comprises the third material at a grain boundary between adjacent grains. This further enhances phonon scattering.

### Fifth implementation - growing layer

As discussed above, the growing layer comprises or consists of a monocrystalline material. A monocrystal can be described using a set of crystallographic axes. The orientation of a crystal can be specified by the angles between these axes or by the orientation of specific crystallographic planes or directions relative to an external reference frame.

For example, in cubic crystals, which have three mutually perpendicular crystallographic axes of equal length, orientation might be described by specifying the angle between one of these axes and a reference axis.

The orientation of a crystal is crucial in various scientific and technological applications, such as crystal growth, materials science, semiconductor technology, and studies of crystallography. It plays a significant role in determining the properties and behavior of the crystal in various contexts.

According to fifth implementation of the first solution, an angle between a crystallographic axis of the monocrystalline growing layer and a surface normal of the growing surface is equal to or greater than 0°. Preferably, the angle is equal to or greater than 2°. As for example discussed in EP 1 200 651 B1, such an orientation, in particular being greater than 0° and/or less than or equal to 8°, preferably less than or equal to 6°, facilitates the growth of a high quality crystal.

Further, the terms "C-face" and "Si-face" are commonly used in the context of crystal growth, particularly in semiconductor materials such as silicon carbide (SiC). These terms refer to specific crystallographic planes on the surface of a semiconductor crystal, which have different properties and reactivities.

The C-face (Carbon face) of a semiconductor crystal, such as SiC, refers to the surface plane predominantly composed of carbon atoms. This surface plane tends to have a higher concentration of carbon atoms, which can influence the surface chemistry and reactivity of the crystal. The C-face may exhibit different surface properties compared to other crystallographic planes, impacting the growth and properties of thin films or other structures deposited on this surface. For example, growth of the desired 4H polytype takes place on the carbon-terminated surface of a SiC wafer.

The Si-face (Silicon face) of a semiconductor crystal, such as silicon carbide (SiC), refers to the surface plane predominantly composed of silicon atoms. This surface plane tends to have a higher concentration of silicon atoms, which can influence the surface chemistry and reactivity differently from the C-face.

### Sixth implementation - connecting layer

According to a sixth implementation of the first solution, as shown in FIG. 1, the polycrystalline layer 140 can be bonded to the monocrystalline layer 110 by a connection layer 160. In doing so, a connection must be created that is temperature-stable up to approximately 2000°C to 2400°C.

According to variants, the connecting layer 160 comprises an organic compound as phenolic resin or novolac resin. Additionally or alternatively, the connecting layer 160 can comprises a sintered powder, preferably sintered silicon powder.

Phenol resins, also known as phenolic resins, are a type of thermosetting polymer derived from the reaction between phenol (or substituted phenols) and formaldehyde. A novolac resin, often referred to simply as novolak, is a type of thermosetting resin derived from the condensation reaction between phenol (or substituted phenols) and formaldehyde in the presence of an acid catalyst. Sintering can be used to connect or bond two layers of material together, particularly in the context of powder metallurgy or ceramic processing. In particular, by interlayer sintering a layer of powder is placed between two layers that need to be bonded. When the entire assembly is subjected to sintering conditions, the powder in the interlayer undergoes sintering, forming a bond between the adjacent layers.

According to a further implementation, as shown in FIG. 1, the polycrystalline layer 140 can be bonded to the seed holder 1120 by a connection layer 1120. The connecting layer 1120 may be realized according to any of the variants discussed above in view of the connecting layer 160. Additionally or alternatively, the connecting layer 1120 may be omitted and the polycrystalline layer 140 be ben hold by clamping it by the seed holder 1120.

### Second solution - method for fabricating the layered seed

The layered seed as for example shown in FIG. 1 can be fabricated by the following steps:
providing a monocrystalline growing layer 110 with a growing surface 112 for growing the volume mono crystal and an opposing heat spreader facing surface 114 for coupling the growing layer 110 to a heat spreader layer 140; and
providing the heat spreader layer 140 with an growing layer facing surface 144 for coupling to the heat spreader facing surface 114 and an opposing mounting surface 142 for mounting the heat spreader 140 to the crucible,
wherein the heat spreader layer 140 comprises a polycrystalline material having thermally coupled grains 146 that are piled in the direction of growth Y, the piled grains for equalizing hot spots of the crucible thermally coupled to the mounting surface 142, and
connecting the growing layer facing surface 114 to the heat spreader facing surface 144.

For the description of the components is referred to the above discussed first solution and in particular to the implementations.

In particular, the method of fabrication comprises the connecting step as discussed in the sixth implementation. Correspondingly, the method comprises connecting the growing layer facing surface to the heat spreader facing surface by a at least one of a gluing step and a sintering step for forming a connecting layer between the monocrystalline growing layer and the heat spreader layer.

**Third solution** - **method for growing a volume mono crystal** The layered seed as for example shown in FIG. 1 can be used in method for growing a volume mono crystal. The growing method comprises the steps:
Mounting a layered seed according to the first or second solution in a crucible,
Growing, by a gas phase growth process, the volume mono crystal on the monocrystalline growing layer.

For the description of the layered seed is referred to the above discussed first and second solution and in particular to the implementations.

In particular, the method of growing the volume mono crystal comprises the mounting step of mounting the layered seed to a seed holder 1120 in the crucible as for example described in the sixth implementation of the first solution. For example, the mounting layer is glued or sintered to the seed holder. Additionally or alternatively, the heat spreader layer is clamped by the seed holder.

Further, various sublimation growth process have been discussed in the section sublimation growth. For example, the volume mono crystal is grown by physical vapor transport (PVT) process. As discussed above, for sublimation growth process and in particular for the PVT-process, the growing comprises heating the layered seed to a temperature of equal to or greater than 2000°C and/or less than or equal to 2400°C.

| **Reference Numeral** | **Description** |
|---|---|
| 110 | monocrystalline growing layer |
| 112 | growing surface |
| 114 | heat spreader facing surface |
| 140 | heat spreader layer |
| 142 | mounting surface |
| 144 | growing layer facing surface |
| 146 | Grain |
| 148 | Grain boundaries |
| 160 | connecting layer |
| 252, 1252 | Temperature profile |
| 300 | phonon |
| 1000 | system for sublimation growth |
| 1110 | seed crystal |
| 1120 | seed holder |
| 1130 | connecting layer |
| 1200 | crucible |
| 1210 | End wall |
| 1212 | Temperature profile |
| 1250 | growth region |
| 1260 | storage region |
| 1300 | tubular container |
| 1400 | induction heating |

## Claims

1. Layered seed for growing a volume mono crystal by gas phase growth in a direction of growth (Y) in a crucible (1200), the layered seed comprising:
a monocrystalline growing layer (110) with a growing surface (112) for growing the volume mono crystal and an opposing heat spreader facing surface (114) for coupling the growing layer (110) to a heat spreader layer (140); and
the heat spreader layer (140) with a growing layer facing surface (144) for coupling to the heat spreader facing surface (114) and an opposing mounting surface (142) for mounting the heat spreader (140) to the crucible (1200),
wherein the heat spreader layer (140) comprises a polycrystalline material having thermally coupled grains (146) that are piled in the direction of growth (Y), the piled grains (146) for equalizing hot spots of the crucible thermally coupled to the mounting surface.

2. Seed according to claim 1, wherein the monocrystalline growing layer (110) has a thickness in the direction of growth (Y) of equal to or greater than 0.5 mm and/or less than or equal to 1.0 mm, and/or wherein the heat spreader layer (140) has a thickness in the direction of growth (Y) of equal to or greater than 0.5 mm and/or less than or equal to 3.0 mm,
optionally wherein the layered seed has a diameter in a radial dimension (r) of equal to or greater than 155 mm, preferably equal to or greater than 210 mm and/or less than or equal to 360 mm, the radial dimension (r) is perpendicular to the direction of growth (Y).

3. Seed according to any of the proceeding claims, wherein a median grain diameter, D50, is equal to or greater than 3 µm and/or less than or equal to 80 µm, preferably wherein D50 is equal to or greater than 3 µm and/or less than or equal to 50 µm,
optionally wherein a number of grains piled in the heat spreader layer (140) in the direction of growth (Y) is equal to or greater than 167 and/or less than or equal to 1000.

4. Seed according to any of the proceeding claims, wherein the monocrystalline growing layer (110) comprises a first material, the first material being at least one of SiC, AIN, GaN, AlGaN, AllnN, and InN, and/or the grains of the heat spreader layer (140) comprise a second material, the second material being at least one SiC, AIN, GaN, Al2O3, GaAs and oxide substrate,
optionally wherein the second material is identical to the first material and the first material being at least one of Si, SiC, AIN, and GaN, or wherein the first material is different from the second material,
optionally wherein the monocrystalline growing layer (110) consists of the first material.

5. Seed according to any of the proceeding claims, wherein the heat spreader layer (140) comprises a third material, the third material being a metal, preferably, wherein the third material being at least one of Ti, Fe, W, Mo, and V.

6. Seed according to any of the proceeding claims, wherein the grains of the heat spreader layer (140) comprise a second material and the heat spreader layer comprises a third material, the third material having a higher a higher mass than the second material,
optionally wherein the heat spreader layer comprises the third material at a grain boundary between abutting grains,
optionally wherein the second material being at least one SiC, AIN, GaN, Al2O3, GaAs and oxide substrate,
optionally wherein the third material being a metal, preferably, wherein the third material being at least one of Ti, Fe, W, Mo, and V.

7. Seed according to any of the proceeding claims, wherein the heat spreader layer (140) comprises a concentration of impurities, wherein the concentration is equal to or greater than 5 ppm and/or less than or equal to 100 ppm at grain boundaries,
optionally wherein the impurities comprise a third material being a metal, preferably, wherein the third material being at least one of Ti, Fe, W, Mo, and V.

8. Seed according to any of the proceeding claims, wherein an angle between a crystallographic axis of the monocrystalline growing layer (110) and a surface normal of the growing surface (112) is equal to or greater than 0° and/or less than or equal to 8°, preferably the angle is equal to or greater than 2° and/or less than or equal to 6°.

9. SiC-Seed according to any of the proceeding claims, wherein the growing surface (112) comprises a carbon face, C-face, preferably the growing surface is a C-face.

10. Method for fabricating a layered seed for growing a volume mono crystal by gas phase growth in a direction of growth (Y) in a crucible, the method comprises the steps of:
providing a monocrystalline growing layer (110) with a growing surface (112) for growing the volume mono crystal and an opposing heat spreader facing surface (114) for coupling the growing layer to a heat spreader layer (140); and
providing the heat spreader layer (140) with an growing layer facing surface (142) for coupling to the heat spreader facing surface (114) and an opposing mounting surface (142) for mounting the heat spreader to the crucible,
wherein the heat spreader layer (140) comprises a polycrystalline material having thermally coupled grains (146) that are piled in the direction of growth (Y), the piled grains (146) for equalizing hot spots of the crucible thermally coupled to the mounting surface (142),
connecting the growing layer facing surface (144) to the heat spreader facing surface (114).

11. Method according to claim 10, wherein the growing layer facing surface (144) is connected to the heat spreader facing surface (114) by a at least one of a gluing step and a sintering step for forming a connecting layer (160) between the monocrystalline growing layer (110) and the heat spreader layer (140).

12. Method for growing a volume mono crystal in a direction of growth (Y), the method comprising the steps of:
Mounting a layered seed according to any of claims 1 to 10 or a layered seed fabricated according to the method of claims 11 to 12 in a crucible,
Growing, by a gas phase growht process, the volume mono crystal on the monocrystalline growing layer (110).

13. Method according to claim 12 wherein
the heat spreader layer (14) is mounted to a seed holder (1120) in the crucible, optionally wherein the mounting surface (142) is glued or sintered to the seed holder (1120).
optionally wherein the heat spreader layer (140) is clamped by the seed holder (1120).

14. Method according to any of claims 12 to 13, wherein
the volume mono crystal is grown by physical vapor transport, PVT, optionally wherein growing comprises heating the layered seed to a temperature of equal to or greater than 2000°C and/or less than or equal to 2400°C.
